# EUROPEAN PATENT SPECIFICATION

(11) **EP 2 000 558 B1**
(45) Date of publication and mention of the grant of the patent: **28.09.2011**
(21) Application number: 07704762.9
(22) Date of filing: 31.01.2007
(51) Int. Cl.: C23C 14/02, C23C 14/34

(54) **METHOD AND APPARATUS FOR MANUFACTURING PURELY REFRACTIVE OPTICAL STRUCTURES**
VERFAHREN UND VORRICHTUNG ZUR HERSTELLUNG VON REIN REFRAKTIVEN OPTISCHEN STRUKTUREN
PROCÉDÉ ET APPAREIL DE FABRICATION DE STRUCTURES OPTIQUES DE RÉFRACTION PURE

(30) Priority: 09.03.2006 ES 200600592
(43) Date of publication of application: 10.12.2008
(73) Proprietor: Universidad de Cadiz, 11001 Cadiz (ES)
(72) Inventor: GONZÁLEZ LEAL, Juan María, E-11510 Puerto Real (Cádiz) (ES); ÁNGEL RUIZ, José Andrés, E-11510 Puerto Real (Cádiz) (ES)
(74) Representative: ABG Patentes, S.L.
(86) International application number: PCT/ES2007/000053
(87) International publication number: WO 2007/101895

(56) References cited:
- WO-A1-00/44960
- GB-A- 2 300 001
- US-A- 4 701 592
- US-A- 5 737 123
- US-A- 5 760 366
- US-A- 5 952 271
- US-B2- 6 924 457
- ZIMMER ET AL: "Precise etching of fused silica for refractive and diffractive micro-optical applications" OPTICS AND LASERS IN ENGINEERING, ELSEVIER LNKD- DOI:10.1016/J.OPTLASENG.2004.12.003, vol. 43, no. 12, 1 December 2005 (2005-12-01), pages 1349-1360, XP005004019 ISSN: 0143-8166
- DATABASE WPI Week 1992, Derwent Publications Ltd., London, GB; AN 1992-101722 & JP 04 045 263 A 14 February 1992

## Description

### REFERENCES CITED

### PATENTS

US 5053171 10/1991 Portney et al.
US 5345336 9/1994 Aoyama et al.
US 5737126 4/1998 Lawandy
US 6110291 8/2000 Haruta et al.
US 6668588 B1 12/2003 Hilton et al.
US 6924457 B2 8/2005 Koyama et al.

### OTHER PUBLICATIONS

J.H. McLeod, "The axicon: a new type of optical element", J. Opt. Soc. Am. 44 (1954) 592.
A.V. Kolobov and Ka. Tanaka, in "Photoinduced Phenomena in Amorphous Chalcogenides: From Phenomenology to Nanoscale", Handbook of Advanced Electronic and Photonic Materials and Devices, Vol. 5, Hari Singh Nalwa, ed. (Academic Press, San Diego, 2001), p. 47.
A. Zakery, Y. Ruan, A. V. Rode, M. Samoc and B. Luther-Davies, "Low-loss waveguides in ultrafast laser-deposited As2S3 chalcogenide films", J. Opt. Soc. Am. B 20 (2003) 1844.

### FIELD OF THE INVENTION

The present invention lies within the field of optical elements with refractive functions, and methods of manufacturing them.

### PRIOR ART

Optical elements are very important in all technological fields where it is necessary to modulate the spatial distribution of light. Bearing in mind this requirement, it is necessary to optimise techniques of manufacturing simple optical structures and producing optical structures with new functions.
Most of the methods used to manufacture refractive optical elements on a medium-sized scale use repeated cutting and polishing processes, or heated moulding processes [US 6668588 B1], prior to more complex subsequent treatments. Alternatively, different processes have been developed to manufacture elements on a small scale, based on complex multiple surface micromachining, or photolithography steps [US 5345336], and more recent methods that propose the ablation of plastic or glass surfaces [US 5053171], or the heat-assisted structural modification of semiconductor doped glass surfaces [US 5737126] using lasers. Furthermore, due to their connection with the invention disclosed and claimed herein, it is also important to mention methods of light-assisted deposits that are used in planar technology production processes [US 6110291], the aim of which is to create a uniform layer of conductor, semiconductor or superconductor compounds on a substrate to form active and passive optical devices [US 6924457 B2] and/or planar electronic devices.
The present invention discloses a simple method of manufacturing refractive optical elements, which is based on the light-assisted control of the profile of a semiconductor material that will be deposited on a substrate that is transparent to the working radiation for which the optical element to be manufactured is designed. The method makes it possible to extend the functions of the optical elements that are manufactured so that they may be used at high light intensities.
To the applicants' understanding, the patents cited in this section are, within the scope of our search, those that cover the most relevant inventive activities within the context of that disclosed herein, and the inventive activity claimed by the applicants for the present invention can be demonstrated on the basis of these patents.

### BASIS OF THE INVENTION

The present invention discloses a simple, although not obvious, method for the light-assisted manufacturing of optical elements, which is based on the following physical facts:
1. Structural fragments of the constituent elements of semiconductor compounds can be ejected from a solid when they are irradiated with light whose photon energy is comparable (in the order of magnitude) to its optical gap, with a high enough intensity. This intensity depends on the type of semiconductor material.
2. The vapour phase, or plasma plume, that is generated condenses on a substrate located in the proximity of the starting material, causing this material to be deposited on the substrate.
3. The morphology of the deposit is related to the characteristics of the plume or vapour phase, which depend on the spatial light intensity distribution on the target material, the spectral radiance of the light source, the distance between the target material and the substrate, the pressure and the atmosphere in the chamber, the temperature of the starting material, the temperature of the substrate, and the irradiation time.
4. Concurrent illumination of the deposit during its growth may affect the physicochemical properties of the material that forms said deposit, as a consequence of its effect on the structure being formed.

On the basis of the aforementioned facts, the applicants of the present patent propose a simple but not obvious method of manufacturing optical elements with a purely refractive function as defined in independent claim 1.

In a preferred embodiment of the invention, which is not limiting in terms of the material used or the configuration of the manufacturing system, a continuous laser beam, with a wavelength of 532 nm and a Gaussian light intensity distribution, perpendicularly crosses a transparent substrate with planoparallel sides before reaching a target material situated a few millimetres from the substrate. Said target material is a disc (wafer) with a diameter of around 1 cm and a thickness of 2 mm, made from compacted powder of an amorphous V-VI semiconductor alloy (e.g. an alloy of As and S), which is sensitive to the photon energy of light radiation from a Nd:YAG laser (2.33 eV). The sides of the substrate and the wafer that face each other are parallel.

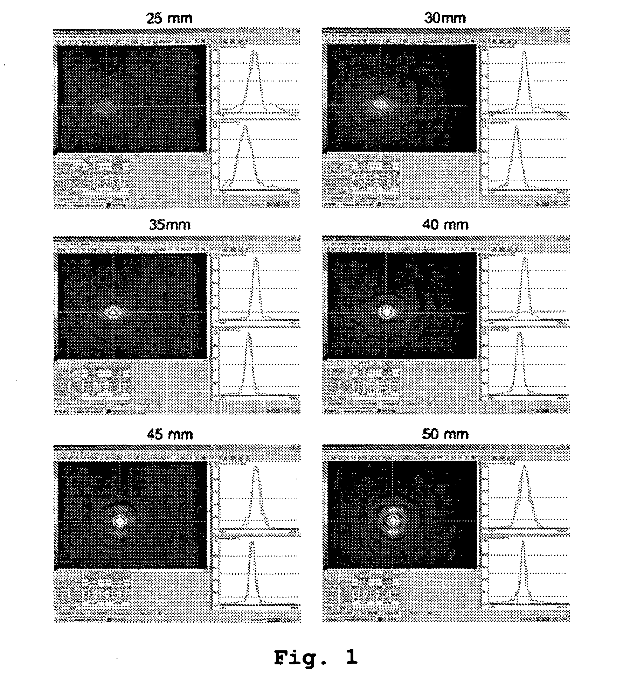

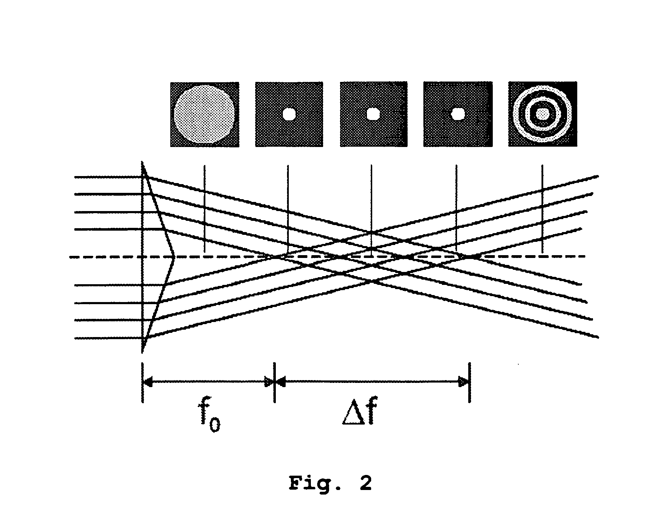

The above-described configuration produces a deposit with an aspheric profile that generates an optical function as shown in Figure 1, which is characteristic of optical elements called axicons [McLeod]. Axicons, as shown in Figure 2, unlike lenses with conventional spherical profiles, are characterised in that they concentrate light energy along a focal segment that extends along the optical axis, and their lateral resolution remains constant to propagation on this focal segment.

The transparency of V-VI semiconductors in the infrared (IR) spectral region [Kolobov and Tanaka] guarantees the stability of the optical elements manufactured in this spectral window, therefore making it the preferred working spectral region.

However, the applicants of the present patent have observed that the optical elements produced according to the above-described preferred embodiment present a greater optical transparency and a higher damage threshold to the laser radiation used in the manufacturing process compared to that of the starting material, possibly due to concurrent uniform illumination of the material being deposited. In experiments, an increase of more than one order of magnitude has been observed in the damage intensity in alloys with a composition of As₂₀S₈₀, in relation to the intensity supported by the starting material.

Furthermore, due to its relevance to the present invention, it has been shown [Zakery et al.] that coating an amorphous chalcogenide deposit with a layer of polymethyl methacrylate (PMMA) increases by several orders of magnitude the damage threshold to radiation for which the chalcogenide alloy would be sensitive without any coating.

In view of such facts, both of our own and reported in the literature, it can be inferred that although the IR region is the preferred window, it should not be considered the only one.

### DESCRIPTION OF THE FIGURES

- FIGURE 1.: Light intensity distribution along the focal axis corresponding to an axicon manufactured according to the present invention, using an amorphous alloy with a composition of As₂₀S₈₀. The distances are measured in relation to the position of the axicon. A lateral resolution of ∼ 60 µm is achieved at a distance of 35 mm from the axicon, and is maintained up to 45 mm, the position from which the energy begins to couple to higher modes than the zero order mode. The wavelength of the laser radiation used in these measurements was 532 nm.
- FIGURE 2.: Diagram showing how an extended focal lens (axicon) works. This aspheric optical element presents a focal region on the optical axis with a high lateral resolution (of the order of microns) and a long depth of focus, Δf, from an initial focusing distance f₀. The light intensity distribution at different distances along the optical axis is also shown.

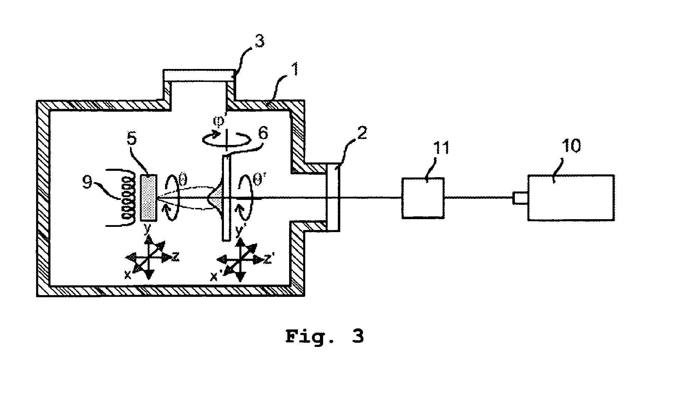

- FIGURE 3.: Cross-sectional diagram of a system for producing optical elements with a purely refractive function according to the method of the present invention, in a basic configuration wherein a light beam falls on the starting material at normal incidence, after crossing a transparent substrate. It shows:
1.- Chamber.
2 and 3.- Transparent windows in the chamber.
5.- Starting material.
6.- Substrate.
9.- Heat source.
10.- Source of light radiation.
11.- Opto-mechanical means of control.

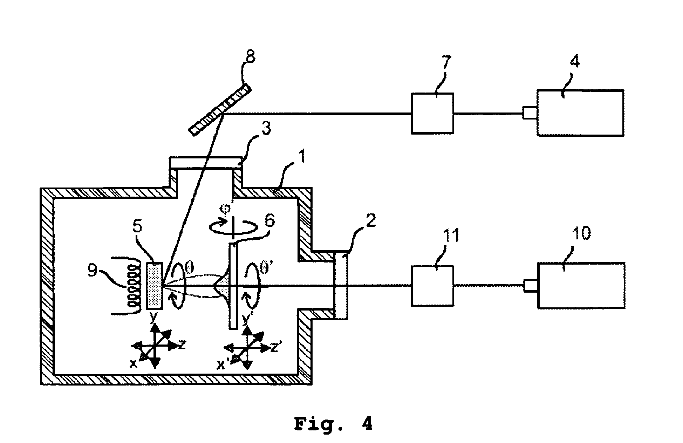

- FIGURE 4.: Cross-sectional diagram of a system for producing optical elements with a purely refractive function according to the method of the present invention, in a basic configuration wherein two light beams fall on the starting material, one with normal incidence to the starting material, which crosses the substrate, and a second light beam that falls obliquely on the material without crossing the substrate. It shows:
1.- Chamber.
2 and 3.- Transparent windows in the chamber.
4.- Source of light radiation.
6.- Substrate.
7.- Opto-mechanical means of control.
8.- Mirror.
9.- Heat source.
10.- Source of light radiation.
11.- Opto-mechanical means of control.

### DESCRIPTION OF THE INVENTION

The present invention proposes a method according to claim 1 for manufacturing optical elements with a purely refractive function in a simple and economical way and an optical element with a purely refractive function according to claim 12, produced by said method. This method includes the following steps: (a) situating a substrate 6, which is transparent to both the working radiation to which the optical element to be manufactured is designed and the radiation used in the manufacturing process, close to a starting material 5, both of which are situated inside a chamber 1; (b) irradiating the substrate 6 so that the light radiation crosses it; (c) exposing the starting material 5 to the radiation transmitted through the substrate 6, so that as the radiation falls on the starting material 5 its evaporation or sublimation occurs; (d) depositing the vapour phase of the starting material 5 on the substrate 6; and (e) concurrently and uniformly irradiating the deposit of material through the substrate 6 during the deposition process in order to increase the stability of the optical device at high working light intensities. The maufactured optical element presents a refractive optical function due to its composition and profile, as well as an increase in the damage threshold at high light intensities.

The objects of the present invention are as follows:
- to provide a simple method of manufacturing optical elements with a refractive function,
- to provide a method of manufacturing refractive optical elements using light radiation,
- to provide a method of manufacturing aspheric refractive optical elements,
- to provide a method of manufacturing optical elements with a refractive function, without revolution symmetry,
- to provide a method of manufacturing refractive optical elements with extended functions at high light intensities.

Figure 3 shows a preferred embodiment according to the proposed method for manufacturing optical elements with a refractive function. With reference to this figure, the system consists of a chamber 1 with transparent windows 2 and 3, and a source of continuous or pulsed light radiation 10, a starting material 5, and a substrate 6 which is transparent to the radiation from the source of light radiation 10, and also transparent to the working radiation for which the optical element to be manufactured is designed. The light beam from the source of light radiation 10 enters the chamber through a transparent window 2, and crosses the substrate 6 before falling on the starting material 5, causing its ejection. The generation of this plume can be assisted by heat from a heat source 9. The deposition can also be thermally assisted by supplying heat to the substrate, in a similar way to the heat source 9 (not shown in Figure 3). The spatial intensity distribution on the starting material is controlled by opto-mechanical means of control 11, which are a combination of optical (lenses, mirrors, filters, masks, spatial light, phase and amplitude modulators, etc.) and/or mechanical (linear positioning stages, angular positioning stages, mechanical spatial light modulators, etc.) elements. The deposition is carried out at a controlled pressure and atmosphere.
The starting material 5, which is situated inside the chamber, can be an ingot of a semiconductor alloy, or a wafer made from the alloy to be deposited in powder form. The wafer can be a homogeneous or heterogeneous mixture of semiconductor alloys containing a chalcogen element (O, S, Se and/or Te) and other reactants (e.g. Ge, Ga, Si, P, As, Sb, I, Pm, Sm, Eu, Er, etc.), which act as both passive and active elements for a determined light radiation. The starting material used in the example shown in Figure 1 is an amorphous alloy with a composition of As₂₀S₈₀. The starting material is supported by a mechanical means of support, which is a combination of mechanical elements that give it freedom to move in the three Cartesian directions, x, y, z, and to rotate around an axis that is perpendicular to its surface, θ.

The substrate 6 is supported by a mechanical means of support, which is a combination of mechanical elements. The substrate is thus free to move in the three Cartesian directions, x', y', z', as well as to rotate around an axis that is perpendicular to its surface, θ', and around an axis that is parallel to its surface, ϕ', in a way that is not integral to the starting material.

Figure 4 shows a second preferred embodiment according to the proposed method for manufacturing optical elements with a refractive function. With reference to this figure, and similarly to that described for Figure 3, the system consists of a chamber 1 with transparent windows 2 and 3, two sources of continuous or pulsed light radiation 4 and 10, a starting material 5, and a substrate 6 which is transparent to the radiation from the source of light radiation 10, and also transparent to the working radiation for which the optical element to be manufactured is designed. The spatial intensity distribution on the starting material is controlled by opto-mechanical means of control 7, 11, which are a combination of optical (lenses, mirrors, filters, masks, spatial light, phase and amplitude modulators, etc.) and/or mechanical (linear positioning stages, angular positioning stages, mechanical spatial light modulators, etc.) elements. The light beam from a first source of light radiation 4 enters the chamber through the window 3, after falling on a mirror 8. The mirror 8 is mounted on translation and rotary positioning stages that give it degrees of freedom to control, in combination with the Opto-mechanical means of control 7, the light intensity distribution on the starting material. The light beam from a second source of light radiation 10 enters the chamber through the window 2, and crosses the substrate 6 before falling on the starting material 5. The beam from the source of light radiation 4 and the beam from the source of light radiation 10 do not necessarily fall on the same area of the starting material. The generation of the plume can be assisted by heat from a heat source 9. The deposition can also be thermally assisted by supplying heat to the substrate, in a similar way to the heat source 9 (not shown in Figure 4). The deposition is carried out at a controlled pressure and atmosphere.

The systems shown in Figures 3 and 4 involve the uniform illumination of the deposit during its growth. This concurrent uniform irradiation may modify the properties of the material being deposited, depending on its nature and the characteristics of the light radiation that falls on it. This may produce, for instance, a more stable material, with a higher damage threshold, and it may therefore extend its functions at high light intensities, as has been described above on the basis of experimental results.

A real embodiment is described below to illustrate the use of the present invention for manufacturing a refractive axicon that is stable and highly transparent in the IR region. The starting material, in this case, is a circular wafer with a 13 mm diameter, made from 125 mg of powder, compacted for 10 minutes with a 10-tonne load, of an amorphous chalcogenide alloy with a composition of Aₛ₂₀S₈₀, which presents an optical gap of 2.1 eV. The pressure in the chamber is reduced to below 10⁻⁴ mbar. The light radiation comes from a Nd:YAG continuous laser generator emitting at 532 nm (2.33 eV), with a power of 400 mW. The laser beam induces the ejection of the starting material by ablating the surface of the wafer, generating a distribution of the vapour phase in the form of a spindle (plume), which is perpendicular to the irradiated surface of the wafer. The transparent substrate is situated inside the chamber, in the path of the light beam, at 2 mm from the starting material, so that the beam crosses both sides of the substrate before falling on the starting material. The vapour phase of the starting material condenses on the side of the substrate that faces this material, presenting an aspheric spatial distribution on its surface, which has an optical function as shown in Figure 1.

The conditions of the system may be adjusted to deposit a uniform profile or a profile of a variable thickness, concentrated on a localised region of the substrate or extended across it arbitrarily. The area covered by the deposit and the thickness profiles may be controlled by moving the light beam over the surface of the starting material and/or the substrate by means of the positioning stages that give the starting material and the substrate the degrees of freedom x, y, z, θ, x', y', z', θ', ϕ', respectively, which are shown in the diagrams in Figures 3 and 4.

## Claims

1. Method for manufacturing optical elements with a purely refractive function, **characterised in that** it comprises the following operative stages:
(a) situating a substrate (6), which is transparent to both the working radiation to which the optical element to be manufactured is designed and the radiation used in the manufacturing process, close to a starting material (5), both of which are situated inside a chamber (1);
(b) irradiating the substrate (6) so that the light radiation crosses it;
(c) exposing the starting material (5) to the radiation transmitted through the substrate (6), so that as the radiation falls on the starting material (5) its evaporation or sublimation occurs;
(d) depositing the vapour phase of the starting material (5) on the substrate (6);
(e) concurrently and uniformly irradiating the deposit of material through the substrate (6) during the deposition process in order to increase the stability of the optical element at high working light intensities.

2. Method for manufacturing optical elements with a purely refractive function according to claim 1, **characterised in that** the light radiation involved in the process is continuous or pulsed.

3. Method for manufacturing optical elements with a purely refractive function according to claims 1 and 2, **characterised in that** the light radiation involved in the process is monochromatic or polychromatic.

4. Method for manufacturing optical elements with a purely refractive function according to claims 1 to 3, **characterised in that** the light radiation involved in the process is coherent or incoherent.

5. Method for manufacturing optical elements with a purely refractive function according to claims 1 to 4, **characterised in that** the starting material (5) is an ingot or a wafer made from the pressed powder of the material to be deposited.

6. Method for manufacturing optical elements with a purely refractive function according to claims 1 to 5, **characterised in that** the starting material (5) is a homogeneous or heterogeneous mixture of semiconductor alloys containing a chalcogen element (O, S, Se and/or Te) and other reactants, which act as both passive and active elements for a determined light radiation.

7. Method for manufacturing optical elements with a purely refractive function according to claims 1 to 6, **characterised in that** the process is carried out with a controlled pressure and atmosphere.

8. Method for manufacturing optical elements with a purely refractive function according to claims 1 to 7, **characterised in that** the vapour or plasma phase present in the process results from the evaporation and/or sublimation of the starting material (5) by means of the joint action of heating and light radiation.

9. Method for manufacturing optical elements with a purely refractive function according to claims 1 to 8, **characterised in that** the temperature of the substrate (6) is different to room temperature.

10. Method for manufacturing optical elements with a purely refractive function according to claims 1 to 9, **characterised in that** the refractive optical element that is manufactured presents an optical function corresponding to an axicon-type aspheric lens.

11. Method for manufacturing optical elements with a purely refractive function according to any of claims 1 to 10, **characterised in that** the sides of the starting material (5) and the substrate (6) that face each other are parallel.

## Patentansprüche

1. Verfahren zum Herstellen von optischen Bauelementen mit rein brechender Funktion, **dadurch gekennzeichnet, dass** es die folgende Arbeitsschritte umfasst:
(a) Anordnen eines Substrats (6), das sowohl für die Arbeitsstrahlung, für die das herzustellende optische Bauelement bestimmt ist, als auch für die in den Herstellverfahren verwendete Strahlung transparent ist, nahe einem Ausgangsmaterial (5), wobei beide in einer Kammer (1) angeordnet werden,
(b) Bestrahlen des Substrats (6) derart, dass die Lichtstrahlung es durchsetzt,
(c) Bestrahlen des Ausgangsmaterials (5) mit der Strahlung, die das Substrat (6) durchsetzt hat, so dass die auf das Ausgangsmaterial (5) fallende Strahlung dessen Verdampfen oder Sublimieren bewirkt,
(d) Niederschlagen der Dampfphase des Ausgangsmaterials (5) auf das Substrat (6),
(e) Gleichzeitiges und gleichmäßiges Bestrahlen des Niederschlags des Materials durch das Substrat (6) während des Niederschlagvorgangs, um die Stabilität des optischen Bauelementes bei hohen Arbeitslichtintensitäten zu erhöhen.

2. Verfahren zum Herstellen von optischen Bauelementen mit rein brechender Funktion nach Anspruch 1, **dadurch gekennzeichnet, dass** die in dem Verfahren verwendete Lichtstrahlung kontinuierlich oder impulsförmig ist.

3. Verfahren zum Herstellen von optischen Bauelementen mit rein brechender Funktion nach Ansprüchen 1 und 2, **dadurch gekennzeichnet, dass** die in dem Verfahren verwendete Lichtstrahlung monochromatisch oder polychromatisch ist.

4. Verfahren zum Herstellen von optischen Bauelementen mit rein brechender Funktion nach den Ansprüchen 1 bis 3, **dadurch gekennzeichnet, dass** die in dem Verfahren verwendete Lichtstrahlung kohärent oder inkohärent ist.

5. Verfahren zum Herstellen von optischen Bauelementen mit rein brechender Funktion nach den Ansprüchen 1 bis 4, **dadurch gekennzeichnet, dass** das Ausgangsmaterial (5) ein Gussstück oder eine Scheibe aus gepresstem Pulver des niederzuschlagenden Materials ist.

6. Verfahren zum Herstellen von optischen Bauelementen mit rein brechender Funktion nach den Ansprüchen 1 bis 5, **dadurch gekennzeichnet, dass** das Ausgangsmaterial (5) ein homogenes oder heterogenes Gemisch aus Halbleiterlegierungen ist, die ein Chalkogen (0, S, Se und/oder Te) und weitere Reaktionsmittel enthalten und bei einer bestimmten Lichtstrahlung sowohl als passive wie auch als aktive Elemente wirken.

7. Verfahren zum Herstellen von optischen Bauelementen mit rein brechender Funktion nach den Ansprüchen 1 bis 6, **dadurch gekennzeichnet, dass** das Verfahren bei gesteuertem Druck und gesteuerter Atmosphäre durchgeführt wird.

8. Verfahren zum Herstellen von optischen Bauelementen mit rein brechender Funktion nach den Ansprüchen 1 bis 7, **dadurch gekennzeichnet, dass** die bei dem Verfahren auftretende Dampf- oder Plasmaphase aus dem Verdampfen und/oder Sublimieren des Ausgangsmaterials (5) durch gemeinsame Wirkung von Erwärmung und Lichtstrahlung resultiert.

9. Verfahren zum Herstellen von optischen Bauelementen mit rein brechender Funktion nach den Ansprüchen 1 bis 8, **dadurch gekennzeichnet, dass** die Temperatur des Substrats (6) von Zimmertemperatur verschieden ist.

10. Verfahren zum Herstellen von optischen Bauelementen mit rein brechender Funktion nach den Ansprüchen 1 bis 9, **dadurch gekennzeichnet, dass** das hergestellte brechende optische Bauelement eine optische Funktion entsprechend einer asphärischen Linse des Axicon-Typs aufweist.

11. Verfahren zum Herstellen von optischen Bauelementen mit rein brechender Funktion nach einem der Ansprüche 1 bis 10, **dadurch gekennzeichnet, dass** die einander zugewandten Seiten des Ausgangsmaterials (5) und des Substrats (6) parallel sind.

## Revendications

1. Méthode de fabrication d'éléments optiques ayant une fonction purement réfractive, **caractérisée en ce qu'**elle comporte les étapes fonctionnelles suivantes :
(a) disposer un substrat (6) qui est transparent à la fois aux radiations de fonctionnement auxquelles l'élément optique à fabriquer est destiné et aux radiations utilisées dans le procédé de fabrication, à proximité d'un matériau de départ (5), tous deux étant situés à l'intérieur d'une chambre (1),
(b) irradier le substrat (6) de façon à ce que la radiation lumineuse le traverse,
(c) exposer le matériau de départ (5) à la radiation transmise à travers le substrat (6), de façon à ce que lorsque la radiation tombe sur le matériau de départ (5) on obtienne son évaporation ou sa sublimation,
(d) déposer la phase vaporisée du matériau de départ (5) sur le substrat (6),
(e) en même temps et uniformément irradier le dépôt du matériau à travers le substrat (6) pendant le processus de dépôt afin d'augmenter la stabilité du élément optique à des intensités lumineuses de fonctionnement élevées.

2. Méthode de fabrication d'éléments optiques ayant une fonction purement réfractive selon la revendication 1, **caractérisée en ce que** la radiation lumineuse impliquée dans le procédé est continue ou pulsée.

3. Méthode de fabrication d'éléments optiques ayant une fonction purement réfractive selon les revendications 1 et 2, **caractérisée en ce que** la radiation lumineuse impliquée dans le procédé est monochromatique ou polychromatique.

4. Méthode de fabrication d'éléments optiques ayant une fonction purement réfractive selon les revendications 1 à 3, **caractérisée en ce que** la radiation lumineuse impliquée dans le procédé est cohérente ou incohérente.

5. Méthode de fabrication d'éléments optiques ayant une fonction purement réfractive selon les revendications 1 à 4, **caractérisée en ce que** le matériau de départ (5) est un lingot ou une plaquette réalisé à partie de poudre comprimée du matériau à déposer.

6. Méthode de fabrication d'éléments optiques ayant une fonction purement réfractive selon les revendications 1 à 5, **caractérisée en ce que** le matériau de départ (5) est un mélange homogène ou hétérogène d'alliages semi-conducteurs contenant un élément chalcogène (0, S, Se et/ou Te) et d'autres réactifs, qui agissent comme des éléments passifs et actifs pour une radiation lumineuse déterminée.

7. Méthode de fabrication d'éléments optiques ayant une fonction purement réfractive selon les revendications 1 à 6, **caractérisée en ce que** le procédé est réalisé avec une pression et une atmosphère contrôlées.

8. Méthode de fabrication d'éléments optiques ayant une fonction purement réfractive selon les revendications 1 à 7, **caractérisée en ce que** la phase vapeur ou plasma présente dans le procédé résulte de l'évaporation et/ou de la sublimation du matériau de départ (5) au moyen de l'action conjointe du chauffage et de la radiation lumineuse.

9. Méthode de fabrication d'éléments optiques ayant une fonction purement réfractive selon les revendications 1 à 8, **caractérisée en ce que** la température du substrat (6) est différente de la température ambiante.

10. Méthode de fabrication d'éléments optiques ayant une fonction purement réfractive selon les revendications 1 à 9, **caractérisée en ce que** l'élément optique réfractif qui est fabriqué présente une fonction optique correspondant à une lentille asphérique de type axicon.

11. Méthode de fabrication d'éléments optiques ayant une fonction purement réfractive selon les revendications 1 à 10, **caractérisée en ce que** les côtés du matériau de départ (5) et du substrat (6) qui se font face sont parallèles.
